Europäisches Patentamt

European Patent Office

Office européen des brevets

(11) Publication number: **0 413 159 A2**

# EUROPEAN PATENT APPLICATION

(21) Application number: **90113754.7**

(22) Date of filing: **18.07.90**

(51) Int. Cl.⁵: **H01L 21/363, H01L 31/0296**

The title of the invention has been amended (Guidelines for Examination in the EPO, A-III, 7.3).

(30) Priority: **19.07.89 JP 187990/89**

(43) Date of publication of application:
**20.02.91 Bulletin 91/08**

(84) Designated Contracting States:
**FR GB**

(71) Applicant: **FUJITSU LIMITED**
**1015, Kamikodanaka Nakahara-ku**
**Kawasaki-shi Kanagawa 211(JP)**

(72) Inventor: **Saito, Tetsuo, c/o Fujitsu Ltd.,**
**Patent Department**
**1015 Kamikodanaka, Nakahara-ku**
**Kawasaki-shi, Kanagawa 211(JP)**
Inventor: **Kochi, Tetsuya, c/o Fujitsu Ltd.,**
**Patent Departmen**
**1015 Kamikodanaka, Nakahara-ku**
**Kawasaki-shi, Kanagawa 211(JP)**
Inventor: **Yamamoto, Tamotsu, c/o Fujitsu**
**Ltd., Patent Depart**
**1015 Kamikodanaka, Nakahara-ku**
**Kawasaki-shi, Kanagawa 211(JP)**
Inventor: **Ozaki, Kazuo, c/o Fujitsu Ltd., Patent**
**Depart**
**1015 Kamikodanaka, Nakahara-ku**
**Kawasaki-shi, Kanagawa 211(JP)**
Inventor: **Yamamoto, Kosaku, c/o Fujitsu Ltd.,**
**Patent Depart**
**1015 Kamikodanaka, Nakahara-ku**
**Kawasaki-shi, Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

(54) **Process for growing compound semiconductor layers and detector using such layers.**

(57) A method of growing a ternary or quaternary compound semiconductor layer, including:-
exposing in an enclosure
(a) an initial layer comprising at least two of the elements of the compound semiconductor, and
(b) a source comprising all the elements of the compound semiconductor and having the composition of an off-stoichiometric melt, heating the initial layer and the source, in the enclosure, to place them in a three-phase equilibrium condition, to grow the compound semiconductor layer on/from the initial layer, vapours from the source being transported to the initial layer.

A sensing device using a compound semiconductor layer.

## COMPOUND SEMICONDUCTOR LAYERS.

The present invention relates to compound semiconductor layers. The invention provides a method of growing a ternary or quaternary compound semiconductor layer by vapour phase epitaxy and provides a product using such a layer. The semiconductor layer can be more particularly a II-VI compound semiconductor layer. Still more particularly, but not exclusively, this invention provides a method of growing an epitaxial layer of mercury cadmium telluride (HgCdTe) on a sapphire substrate, and provides a sensing device using the HgCdTe layer on the sapphire substrate.

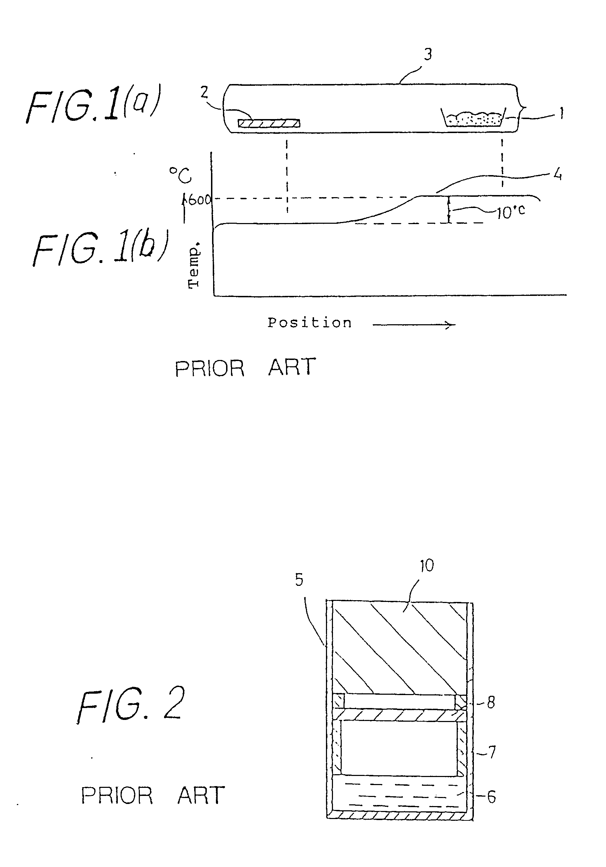

A known method of growing a HgCdTe layer will be explained with reference to schematic Figs. 1(a) and 1(b). Fig. 1(a) shows that a cadmium telluride (CdTe) substrate 2, which is to be subjected to the growth, and a source 1 comprising a melt of mercury (Hg), cadmium (Cd) and tellurium (Te) elements are disposed at opposite respective ends in a tubular enclosure 3. Fig. 1(b) shows a temperature distribution curve 4 for corresponding positions in Fig. 1(a) when the tubular enclosure 3 is placed in a furnace (not shown).

The source 1 is first prepared by providing the above three elements, the weight of each element being determined to correspond to a stoichiometric composition of the $Hg_{1-x}Cd_xTe$ layer to be formed. Three elements are mixed, molten and finally solidified forming the source 1. Satisfaction of the stoichiometric condition means, in other words, that the total amount of mercury and cadmium atoms is substantially equal to that of tellurium atoms, and each of the mercury and cadmium atoms is combined with a tellurium atom, forming HgTe or CdTe.

As shown in Fig. 1(b), the temperature of source 1 is about 600°C, and this temperature is a little higher than those of other regions by about 10°C. Under these conditions, the vapour pressure inside tubular enclosure 3 is higher than about 8 atm; therefore, in order to avoid danger of enclosure explosion or breakage, dimensions of tubular enclosure 3 and the substrate 2 cannot be made as large as is desirable.

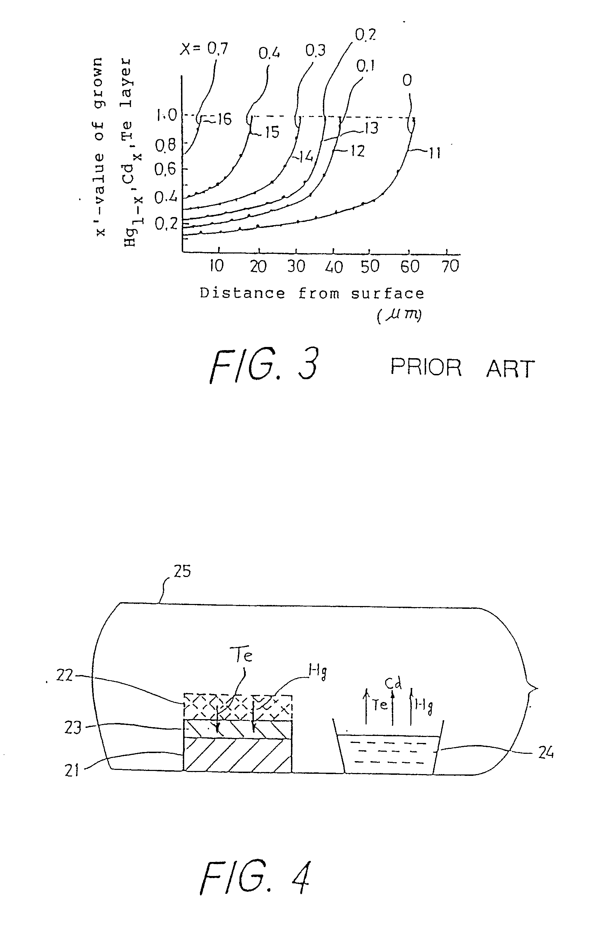

J. G. Fleming et al., "Control of the Surface Composition of Isothermal Vapour Phase Epitaxial Mercury Cadmium Telluride", J. Vac. Sci. Technol. A5(6), Nov./Dec. 1987, discloses a method for controlling the surface composition of mercury cadmium telluride during isothermal vapour phase epitaxy of mercury cadmium telluride. The method employs a source in three-phase solid-liquid-vapour equilibrium for the desired composition and it can avoid the high vapour pressure problem of the above-described method. The method and composition profiles of grown layers will be described in outline with reference to Figs. 2 and 3.

Fig. 2 shows a cross-sectional structure used for tests. The structure comprises a quartz ampoule 5 and a quartz cover plug 10 forming an enclosure. A tellurium-rich source 6 is disposed at the bottom of the ampoule 5, and a CdTe substrate 8 is held above the source 6 spaced therefrom by a quartz spacer 7.

The tellurium-rich source 6 plays an important role in the growth. The source 6 comprises solid stoichiometric mercury cadmium telluride having a composition $Hg_{1-x}Cd_xTe$ and tellurium-rich (hereinafter abbreviated as Te-rich) liquid of off-stoichiometric mercury cadmium telluride having a composition of $(Hg_{1-z}Cd_z)_{1-y}Te_y$ wherein Te-rich liquid is specified by the numeral y which is larger than 0.5. The ratio of solid to liquid is about 9/1. At the growth temperature, the source is maintained in a condition of solid-liquid-vapour equilibrium.

Fig. 3 shows composition profiles of grown layers. The abscissa shows distance from the grown surface and the ordinate shows $x'$-value of the grown epitaxial $Hg_{1-x'}Cd_{x'}Te$ layer using different source compositions. The parameter (x) indicated for each of curves 11 and 12 to 16 in Fig. 3 is the x-value of the solid $Hg_{1-x}Cd_xTe$ composition included in the three-phase solid-liquid-vapour equilibrium source.

As can be seen from Fig. 3, if the parameter x of the solid in the source is equal to 0.2, then the $x'$-values of grown layers are always larger than 0.2. Even in the extreme case of x = 0, which means that the source comprises solid mercury telluride (HgTe) and Te-rich liquid mercury telluride, the grown layer comprises a cadmium component $(x' \geq 0.12)$, for example such as $Hg_{0.88}Cd_{0.12}Te$. By utilising the above method, therefore, mercury cadmium telluride epitaxial layer with a mole fraction of CdTe equal to or less than 0.11 cannot be grown ($Hg_{1-x}Cd_xTe$ having an x-value less than 0.11 cannot be grown).

Fleming's method of growing an HgCdTe epitaxial layer as outlined above utilises a mixture of solid stoichiometric HgCdTe compound of a predetermined composition and Te-rich liquid HgCdTe melt (solution) as the source which is in three-phase equilibrium at the growth temperature. Preparation of source materials which will grow an epitaxial $Hg_{1-x}Cd_xTe$ layer on a CdTe substrate, the layer having a specified mole fraction x of CdTe in the ternary $Hg_{1-x}Cd_xTe$ compound, necessitates complicated process steps. When the desired composition for a grown layer is changed, both source materials have to be prepared again.

According to the present invention there is provided a method of growing a ternary or quaternary compound semiconductor layer, including:-
exposing in an enclosure

(a) an initial layer comprising at least two of the elements of the compound semiconductor, and

(b) a source comprising all the elements of the compound semiconductor and having the composition of an off-stoichiometric melt, heating the initial layer and the source, in the enclosure, to place them in a three-phase equilibrium condition, to grow the compound semiconductor layer on/from the initial layer, vapours from the source being transported to the initial layer.

In embodiments of the present invention the source is a single material source; an off-stoichiometric melt.

Embodiments of the present invention can be employed for producing layers of II-VI compound semiconductor either ternary or quaternary.

For instance, an embodiment of the present invention, can provide a method of growing a $Hg_{1-x}Cd_xTe$ epitaxial layer utilising a single source of Te-rich Hg-Cd-Te melt.

An embodiment of the present invention can provide a method of growing a $Hg_{1-x}Cd_xTe$ epitaxial layer, wherein the value of mole fraction x can be arbitrarily controlled by growth temperature.

An embodiment of the present invention can provide a method of growing a $Hg_{1-x}Cd_xTe$ epitaxial layer, wherein vapour pressure inside an ampoule enclosing a source and substrate is sufficiently low that it is possible to use an ampoule of relatively large diameter and to handle a relatively large substrate.

An embodiment of the present invention can provide a method of growing a $Hg_{1-x}Cd_xTe$ epitaxial layer on a sapphire substrate, the epitaxial layer having an extremely uniform composition throughout its entire thickness.

An embodiment of the present invention can provide a sensing device utilising the above method of growing $Hg_{1-x}Cd_xTe$ epitaxial layer.

An embodiment of the present invention comprises the steps of:-

(a) providing a substrate of such as sapphire which has no interdiffusion with the deposited layer thereon,

(b) first growing a CdTe semiconductor crystalline layer on the substrate by a conventional method,

(c) disposing the substrate with the CdTe crystalline layer and a source in an enclosure, the source comprising Te-rich Hg-Cd-Te melt of a predetermined composition,

(d) heating the substrate and source at a predetermined temperature and growing HgCdTe semiconductor on the CdTe crystalline layer in three-phase equilibrium condition, and

(e) maintaining the step (d) until the whole CdTe crystalline layer is converted to the ternary semiconductor having a predetermined composition of $Hg_{1-x}Cd_xTe$.

Further embodiments of the present invention provide methods of growing other ternary or quaternary semiconductor layers. Moreover, a sensing device produced by these methods is also referred to.

With embodiments of the present invention composition of the semiconductor layer formed can be precisely controlled.

Reference is made, by way of example, to the accompanying drawings, in which:-

Figs. 1(a) and 1(b) illustrate a previously known method of growing HgCdTe epitaxial layer; Fig. 1(a) is a schematic cross-sectional view of an enclosure in which the growth takes place, and Fig. 1(b) shows graphically a temperature distribution in the enclosure of Fig. 1(a) during the growth,

Fig. 2 is a schematic cross-sectional view of an enclosure used for growing an HgCdTe layer in accordance with another known method,

Fig. 3 is a graph showing composition profiles of HgCdTe layers grown by the method of Fig. 2, in which the abscissa gives distance from the grown surface and the ordinate gives x′-value of the grown epitaxial $Hg_{1-x'}Cd_{x'}Te$ layer, for difference source compositions,

Fig. 4 is a schematic cross-sectional view, for assistance in giving an outline explanation of an embodiment of the present invention, showing an enclosure in which a substrate and a source are disposed,

Fig. 5 are cross-sectional views illustrating schematically step-by-step growth of an epitaxial layer on a substrate in accordance with an embodiment of the present invention,

Fig. 6 is a graphical representation illustrating relationships between thickness and x-value of an epitaxial layer being grown,

Fig. 7 is a graph showing liquidus isotherms and solidus lines for the Te-rich corner of the Hg-Cd-Te system,

Fig. 8 is a graph showing partial pressure curves of Hg along the three-phase equilibrium curves for various solid solutions,

Fig. 9 is a schematic cross-sectional view of a growing apparatus which can be employed for carrying out a method embodying the present invention,

Fig. 10 is a graphical representation illustrating temperature distribution along the axis of an enclosure shown in Fig. 9,

Fig. 11 schematically shows a modified arrangement of substrates and source in an enclosure, which can be used in apparatus for carrying out a method embodying the present invention,

Fig. 12 schematically shows another modified arrangement of substrates and source in an enclosure, which can be used in apparatus for carrying out a method embodying the present invention, and

Figs. 13(a) to 13(d) are cross-sectional views of a substrate illustrating sequential steps in the formation of a patterned HgCdTe layer on a substrate in accordance with an embodiment of the present invention.

An embodiment of the present invention will be explained in outline with reference to Fig. 4. On a sapphire ($Al_2O_3$) substrate 21, a CdTe crystalline layer 23 is grown in advance. The substrate 21 with the CdTe crystalline layer 23 is disposed in a quartz ampoule 25. A source 24 comprising Te-rich mercury cadmium telluride melt in a container is also disposed in the ampoule 25, separated from the substrate 21. The Te-rich mercury cadmium telluride melt used for the growth is expressed by the molecular formula $(Hg_{1-z}Cd_z)_{1-y}Te_y$ in which y is larger than 0.5. The source is made by providing three component elements, each having a specified weight, mixing, heating and finally cooling to solid state. Such a source is generally referred to as a melt, regardless of its state or phase, even when the source is in solid state.

The ampoule 25 is heated in a furnace (now shown) and temperature inside the ampoule is brought to the liquidus temperature $T_1$ of the Te-rich Hg-Cd-Te melt. At the liquidus temperature $T_1$, the source 24 comprises stoichiometric HgCdTe solid and Te-rich HgCdTe liquid, and vapour of each component element is produced to develop partial pressures of Hg, Te and Cd. Thereby, Hg partial pressure is predominant with Te partial pressure following next. The solid CdTe layer 23 and the source 24 including solid and liquid states are in three-phase equilibrium, vapours intervening therebetween.

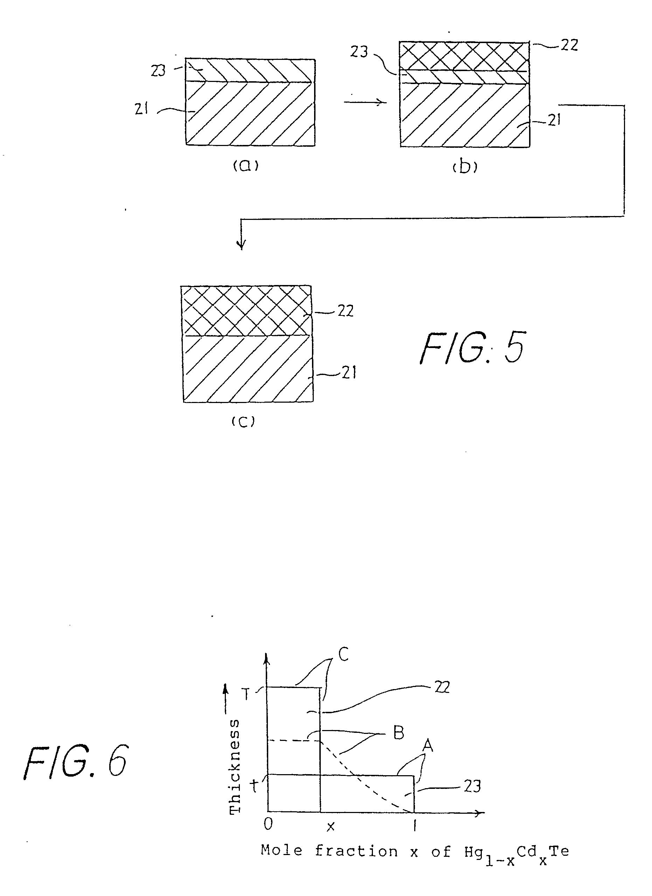

Fig. 5 schematically illustrates growth progress on the substrate 21. The source of Te-rich HgCdTe melt having the predetermined composition precipitates (separates) the solid stoichiometric $Hg_{1-x}Cd_xTe$ having a specified mole fraction x at the liquidus temperature $T_1$.

Vapourised component elements are transported on to the CdTe crystalline layer 23, and react with the layer and isothermal growth takes place. Thermodynamic theory teaches that the grown HgCdTe layer on the CdTe layer 23 in three-phase equilibrium tends finally to grow as a HgCdTe layer having substantially the same composition as the precipitated $Hg_{1-x}Cd_xTe$ solid in the source. Therefore, as seen in Fig. 5(b), transported Hg and Te molecules react with the CdTe layer and interdiffusion of molecules take place, partly eroding the original CdTe crystal layer 23, and growing HgCdTe layer 22, the composition thereof changing gradually from the surface. The reaction continues until the whole grown layer 22 is completely transformed to an epitaxial layer having the composition of $Hg_{1-x}Cd_xTe$, as shown in Fig. 5(c).

Strictly speaking, the distinct boundary surface between original CdTe layer 23 and grown layer 22 in Fig. 5(b) cannot be seen. As shown in Fig. 6, the mole fraction x measured in the thickness direction (of the layers 22, 23) varies gradually. At the beginning of the growth, CdTe layer 23 has an original thickness t and the x-value is unity, as shown by two orthogonal straight lines A. During growth, thickness and x-value are shown by a broken straight line and curve B. At the end of growth, thickness and x-value are as shown by two orthogonal straight lines C.

In an embodiment of the present invention, the thickness t of the initial CdTe layer 23 is preferably selected to be sufficiently small that the whole growth process can be finished in a reasonable time. When lattice constants of CdTe and $Hg_{1-x}Cd_xTe$ are assumed to be $a_1$ and $a_2$ (for a given mole fraction x) respectively, the thickness of the grown $Hg_{1-x}Cd_xTe$ layer can be obtained by the following equation:-

$$T = (ta_2)/(xa_1).$$

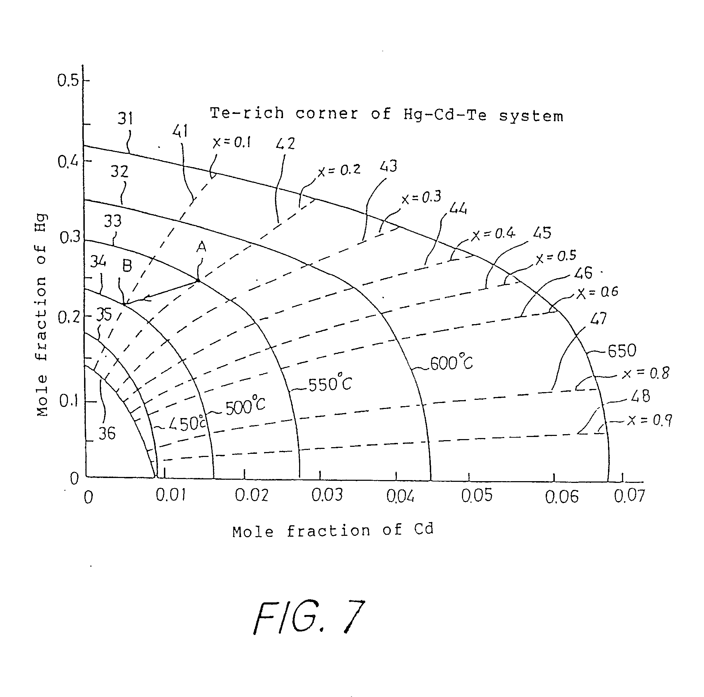

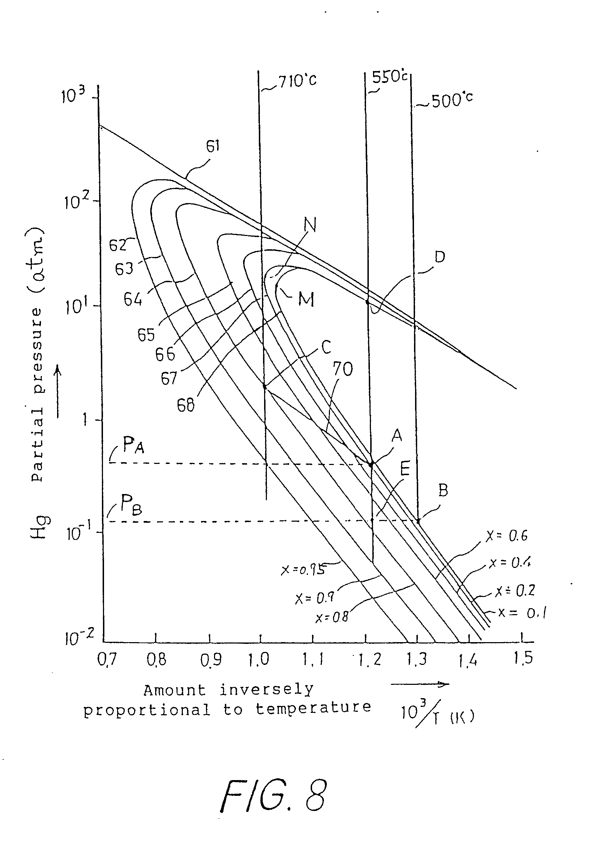

The more detailed analysis of the growth is given with reference to Figs. 7 and 8. Fig. 7 shows liquidus isotherms and solidus lines for the Te-rich corner of the Hg-Cd-Te system. Fig. 8 shows partial pressure curves of Hg along the three-phase equilibrium curves for various solid solutions.

The curves seen in Figs. 7 and 8 are similar to those reported in the following references, but have been modified to facilitate easy application and understanding in relation to the present invention.

T. C. Harman, "Liquidus Isotherms, Solidus Lines and LPE Growth in the Te-rich Corner of Hg-Cd-Te System", J. of Electronic Materials, Vol. 9, No. 6, 1980, and

T. Tung, et al., "Measurement and Analysis of the Phase Diagram and Thermodynamic Properties in the Hg-Cd-Te System, J. Vac. Sci. Technol., Vol. 21, No. 1, May/June 1982.

In Fig. 7, the abscissa gives the mole fraction of Cd in the Hg-Cd-Te system, and the ordinate gives the mole fraction of Hg. This means that, when the melt is expressed by the formula $(Hg_{1-z}Cd_z)_{1-y}Te_y$, the abscissa and ordinate show $z(1-y)$ and $(1-z)(1-y)$ respectively. Solid-line curves 31 to 36 show liquidus isotherms, and broken-line curves 41 to 48 show solidus lines when solids are expressed as $Hg_{1-x}Cd_xTe$, taking mole fractions x for CdTe as parameters.

For example, point A in Fig. 7 is the location of the crossing point of the 550°C liquidus isotherm and the solidus line corresponding to x = 0.2. The abscissa and ordinate data for point A, which are given from Fig. 7 as 0.014 and 0.25 respectively, show the liquid alloy composition to be $Hg_{0.25}Cd_{0.014}Te_{0.736}$, the liquid being in equilibrium at the temperature 550°C with solid $Hg_{0.8}Cd_{0.2}Te$. Because the system is in three-phase equilibrium, growth of $Hg_{0.8}Cd_{0.2}Te$ is observed on a separately located CdTe substrate in the system.

When the temperature of the system is gradually decreased to about 500°C, the equilibrium point moves toward point B in Fig. 7. The CdTe mole fraction x of solid composition separated from the melt changes from 0.2 toward 0.1. In equilibrium at 500°C, $Hg_{0.9}Cd_{0.1}Te$ solid is separated from the melt. This shows that an epitaxial layer of $Hg_{1-x}Cd_xTe$, the x-value being less than 0.11, can be grown by an embodiment of the present invention.

Fig. 8 shows partial pressure of Hg for various conditions of a three-phase equilibrium Hg-Cd-Te system. The abscissa gives amounts which are inversely proportional to the system temperature. A straight line 61 shows vapour pressure of Hg when only liquid Hg is heated in an enclosure. Curves 62 to 68 show partial pressure of Hg when the specified x-value points are connected and, along each curve, CdTe mole fraction x of the separated solid $Hg_{1-x}Cd_xTe$ is constant. Points A and B correspond to the points A and B respectively used in Fig. 7. Point A is located on curve 67 (x = 0.2) and line 550°C in Fig. 8, and point B, on curve 68 (x = 0.1) and line 500°C. The partial pressure of Hg, which is predominant over other component vapours, is at a moderate value and the danger of ampoule explosion is much reduced.

Turnover points M and N in Fig. 8 indicate points at which stoichiometric melts are utilised, the melt for points M and N corresponding to mole fractions x of 0.1 and 0.2 respectively. At these points satisfying stoichiometric conditions, mole fractions of melt and separated solid HgCdTe are the same. Lower portions of curves, from the stoichiometric points, correspond to Te-rich melt, and upper and then asymptotic (to line 61) portions correspond to Hg-rich melt.

When the temperature of the system is raised from point A (550°C) to 710°C, equilibrium position in Fig. 8 moves to point C along the line 70 which is almost parallel to line 61. At point C, solid composition in the melt is shown by the formula $Hg_{0.2}Cd_{0.8}Te$.

Thus, using a growth method embodying the present invention, various kinds of epitaxial HgCdTe layer, of different compositions, can be grown using a single Te-rich melt by controlling the growth temperature. Under the condition such that the substrate and source are maintained at substantially the same temperature, the x-value of the grown epitaxial layer can cover a wide range of x-values, for example from less than 0.11 to greater than 0.8, by changing the system temperature, and the pressure of the system is considerably reduced, to around or less than 1 atm.

Further, embodiments of the present invention may be such that the substrate is heated at a predetermined fixed temperature and the melt is held at a different temperature from that of the substrate, thus making it possible to control the x-value of the grown epitaxial $Hg_{1-x}Cd_xTe$ layer.

For example, when the system is under conditions such that the source and the substrate are held at the same temperature of 550°C and the separated solid in the source melt and grown layer $Hg_{1-x}Cd_xTe$ have the x-value of about 0.2 (point A of Fig. 8), the partial pressure of Hg is shown by $P_A$ in Fig. 8.

However, when the source temperature is reduced to 500°C (point B of Fig. 8) but the substrate is maintained at the temperature of 550°C, then the separated solid in the melt has an x-value of 0.1 and the partial pressure of Hg in the system is shown by $P_B$ in Figure 8. But the composition of the grown epitaxial layer on the substrate, which is grown in equilibrium under partial pressure $P_B$ and the substrate temperature of 550°C, has an x-value of 0.7 which is shown by a point E (cross point of $P_B$ and 550°C lines). The change of x-value is remarkable.

Moreover, when the substrate temperature is fixed at 550°C and the source temperature is raised to a higher temperature than 550°C, composition of the melt and the partial pressure P in equilibrium move along the line 70 (Fig. 8). But, because the substrate temperature is held at the fixed temperature of 550°C, the grown layer on the substrate surface has a composition which is in equilibrium with this higher partial pressure $P_H$. This means the x-value of the grown epitaxial layer on the substrate in equilibrium moves toward 0, but the x-value cannot go lower than 0.

The x-value can approach 0 and, in the extreme case, it becomes 0, and this shows the equivalent condition to a Te-rich HgTe system in equilibrium. This means that (with the source at a temperature higher than the substrate) the source temperature, or the partial pressure P can be controlled to the value which is obtained in the Te-rich HgTe system in equilibrium at the same substrate temperature.

As described above, with embodiments of the present invention utilising one melt having the same composition, a variety of epitaxial layers different in x-value can be obtained. This is the case not only for HgCdTe compositions, but also for other compositions some of which are mentioned in more detail below. There is no need to prepare many kinds of melts different in composition in order to produce sensing devices having different sensitivity/wavelength characteristics.

A more detailed description of one exemplary method in accordance with an embodiment of the present invention is given below.

In this example, a sapphire ($Al_2O_3$) substrate 21 having dimensions of 25 x 30 x 0.04 mm is provided. A CdTe crystalline layer 23 is separately grown on the sapphire substrate 21, whereby thickness of the CdTe crystalline layer is chosen to be 3 to 4 micrometers. The growth method may be based on any one of known technologies such as MOCVD (metal organic chemical vapour deposition), hot-wall epitaxial growth, and PVD (physical vapour deposition), details of which are omitted here.

The grown CdTe crystalline layer 23 does not need to be of a mono-crystalline structure.

The thickness thereof should be determined taking the following fact into consideration. Namely, when $Hg_{1-x}Cd_xTe$ is grown on the CdTe crystalline layer 23 in three-phase equilibrium Hg-Cd-Te system in accordance with an embodiment of the present invention, two layers interact with each other at the interface region and interdiffusion takes place, and finally the whole original CdTe crystalline layer 23 is converted to $Hg_{1-x}Cd_xTe$ crystalline structure and integrated with the subsequently grown $Hg_{1-x}Cd_xTe$, forming one epitaxial $Hg_{1-x}Cd_xTe$ layer. Therefore, the larger the thickness of the CdTe layer 23 is, the longer growth period will be necessary.

In this example, a 3 micrometer thickness is selected for the CdTe layer 23.

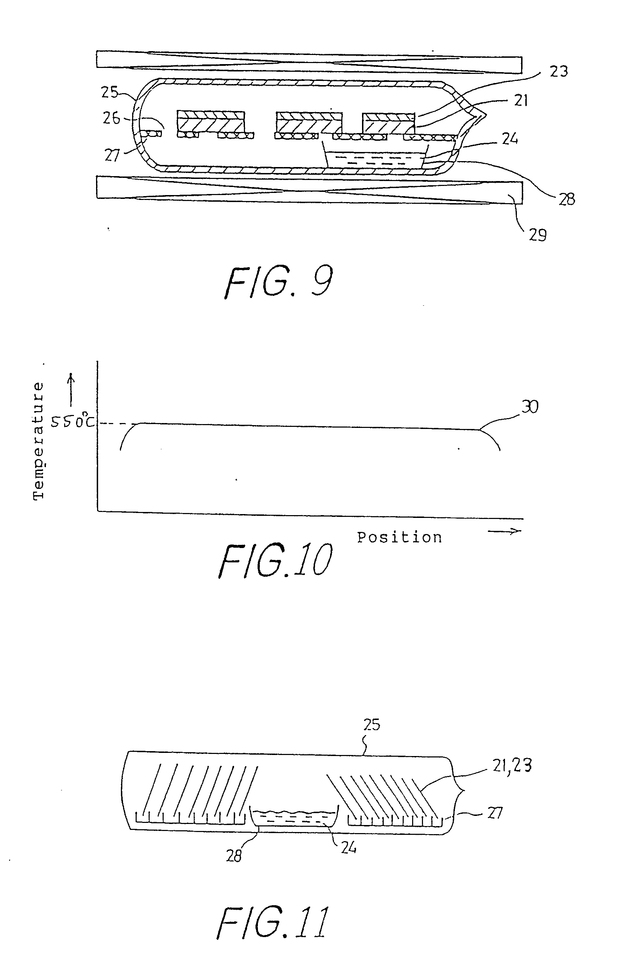

Fig. 9 shows a schematic cross-section of an apparatus which can be used, inter alia, for carrying of the method of this example used for the embodiment. In the apparatus sapphire substrates 21 with CdTe layers 23 are disposed on a quartz holder 27 having openings 26, and the substrate holder 27 is arranged in a quartz enclosure 25. A source 24 contained in a boat 28 is provided under the substrate holder 27. Finally, the enclosure 25 is evacuated and put in a furnace 29. The source 24 used therefor comprises Te-rich Hg-Cd-Te melt which has a composition expressed in an atomic mole fraction formula as $Hg_{0.248}Cd_{0.014}Te_{0.738}$. When this composition is rewritten as a formula $(Hg_{1-z}Cd_z)_{1-y}Te_y$, then $y = 0.738$ and $z = 0.055$. The melt composition corresponds to point A in Fig. 7.

In this example, the enclosure 25 is heated to about 550°C in the furnace 29 and maintained at this temperature for three days. The temperature distribution along the axis of the enclosure is shown by curve 30 in Fig. 10. After the three-day heating, the enclosure is cooled down to room temperature, spending one hour. When the enclosure is opened and the substrates 21 are taken out, it is found that an epitaxial layer having composition of $Hg_{0.8}Cd_{0.2}Te$ is grown on the sapphire substrate 21 and its thickness T is approximately 15 micrometers.

As explained previously, thickness T is given by equation $T = (ta_2)/(xa_1)$. Because the lattice constant $a_1$ of CdTe is known as 6.482Å and the lattice constant $a_2$ of $Hg_{0.8}Cd_{0.2}Te$ as 6.468Å, $a_1/a_2$ is almost unity. Further, since x is 0.2 in this case, thickness T is given to be almost 5t. The grown thickness of about 15 micrometers agrees well with this, and indicates that the present invention achieves the desired result.

In determining the initial thickness t of CdTe crystalline layer 23, the growth time and growth temperature should be taken into consideration. When a growth temperature between 480°C and 600°C is specified and a growth time less than several tens of hours is required, a thickness t less than 10 microns should be used, and preferably a thickness t in the range 2 to 5 microns.

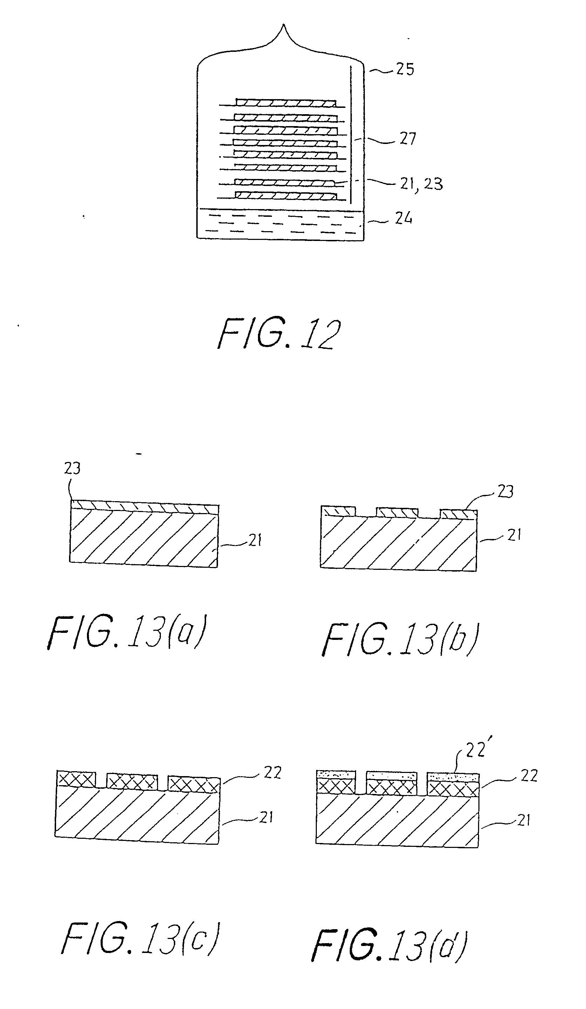

The arrangement of substrates and source can be modified for example as shown in Fig. 11. A boat 28 containing Te-rich Hg-Cd-Te melt is provided at the centre portion of an enclosure 25. Substrate holders 27, which each accommodate a plurality of equally spaced sapphire substrates 21 each with a CdTe crystalline layer 23, are disposed on both sides of boat 28.

Another possible modified arrangement is shown in Fig. 12, in which source 24 is provided at the bottom of vertical-type enclosure 25 and a substrate holder 27 supports a plurality of sapphire substrates 21 each with a CdTe crystalline layer 23.

An embodiment of the present invention can be used to form a patterned HgCdTe layer on a sapphire substrate. Figs. 13(a) to 13(c) show steps involved. Preliminary steps are as previously explained, and a CdTe crystalline layer 23 is formed on a sapphire substrate 21 as shown in Fig. 13(a). A resist layer (not shown) is formed on the substrate and patterned by a conventional photolithography method. Using the patterned resist layer as a mask, the CdTe crystalline layer 23 is patterned as shown in Fig. 13(b). The substrates are then put in an enclosure for growing HgCdTe layer in the same way as explained previously. The growing method is vapour-phase epitaxy, therefore, $Hg_{0.8}Cd_{0.2}Te$ epitaxial layer 22 is selectively grown on sapphire substrate 21 integrated with the patterned CdTe crystalline layer 23 as shown in Fig. 13(c). This method can be particularly effectively used in the production of a multi-element sensing device.

Further, embodiments of the present invention may be applied for producing a quality sensing device in which a sweepout phenomenon is eliminated, the sweepout phenomenon being known or manifest as a saturation tendency in a detected-signal-voltage versus bias-voltage characteristic. This type of the sensing device can be obtained by a structure that the surface of the epitaxial layer of $Hg_{0.8}Cd_{0.2}Te$ 22 of Fig. 13(c) is covered by a thin layer of $Hg_{0.5}Cd_{0.5}Te$.

A method of fabricating such a sensing device in accordance with an embodiment of the present invention is explained with reference to Figs. 13(c) and 13(d). When the structure of Fig. 13(c) is obtained as described above, the system temperature is changed from a three-phase equilibrium condition to the condition such that the substrate temperature is reduced to, for example, 500°C and the source temperature is further reduced to 470°C. This condition is maintained for an hour and thereafter the enclosure is cooled rapidly. A thin epitaxial layer 22' of $Hg_{0.5}Cd_{0.5}Te$ is grown on the former $Hg_{0.8}Cd_{0.2}Te$ layer 22 as shown in Fig. 13(d). The sensing device thus obtained has a high quality without a sweepout phenomenon.

A method embodying the present invention employs a growing method using a three-phase equilibrium system and deposited molecules are transported to a substrate in vapour-phase. Therefore, even when the substrate has an uneven surface, growth is not influenced by the surface unevenness.

To shorten the time required for growing an epitaxial layer in accordance with an embodiment of the present invention it is effective to raise the growth temperature of the enclosure to $T_u$, which is higher than the liquidus temperature $T_1$ of the Te-rich Hg-Cd-Te melt, to maintain the temperature at $T_u$ for a predetermined duration and thereafter to reduce the temperature and maintain it at the liquidus temperature $T_1$.

On the other hand, when growth temperature is held at a temperature $T_d$ lower than the liquidus temperature $T_1$ of Te-rich Hg-Cd-Te melt, the three-phase equilibrium condition changes and the x-value of the grown epitaxial layer is made smaller than the x-value which is obtained in three-phase equilibrium at temperature $T_1$.

This makes it possible to grow HgCdTe epitaxial layers having different mole fractions x by changing the growth temperature, but utilising a single Te-rich Hg-Cd-Te melt having a predetermined composition.

In the above-described embodiments, a sapphire substrate 21 with CdTe crystalline layer thereon is used as a substrate for growing $Hg_{1-x}Cd_xTe$ epitaxial layer. However, embodiments of the present invention are not restricted to this type of substrate. A sapphire substrate with an $Hg_{1-x}Cd_xTe$ crystalline layer thereon can also be used as a substrate, and an epitaxial $Hg_{1-x}Cd_xTe$ layer can be grown on the sapphire substrate in which the mole fraction x of the layer to be grown is different from the x'-value of the layer initially provided on the substrate. The growth method is substantially the same as previously explained.

Further, any of magnesium oxide (MgO), zirconium oxide (ZrO), magnesium aluminium oxide $(MgO.Al_2O_3)$ and silicon covered with silicon oxide $(SiO_2)$ can be used as a substitute for a sapphire substrate. The substrate material should satisfy the condition that the substrate will not suffer any interdiffusion reaction with an epitaxial layer thereon.

The embodiments so far described have related to methods of growing a ternary compound epitaxial layer having a composition $Hg_{1-x}Cd_xTe$. However, embodiments of the present invention can be used for growing ternary compound epitaxial layers of the formula $A_{1-x}B_xC$, in which A is Hg, B is any of Cd, Zn, Mn and Fe, and C is any of Te, S and Se.

Furthermore, embodiments of the present invention can provide methods for growing epitaxial layers of quaternary compound semiconductor, having compositions of, for example, $Hg_{1-x-z}Cd_xZn_zTe$ or $Hg_{1-x}Cd_xTe_{1-z}Se_z$.

A method embodying the present invention, for growing $Hg_{1-x-z}Cd_xZn_zTe$ epitaxial layer will be briefly explained below.

A CdTe crystalline layer is first grown on a sapphire substrate, and next a ZnTe crystalline layer is grown on the CdTe crystalline layer. The thickness ratio of CdTe layer to ZnTe layer is chosen to be about x/z. The substrate with these two layers is placed in an enclosure with a source of Te-rich melt comprising Hg, Cd, Zn and Te elements. The enclosure is heated at a predetermined temperature and the substrate and source are subjected to isothermal vapour-phase epitaxy in three-phase equilibrium, resulting in the growth of a $Hg_{1-x-z}Cd_xZn_zTe$ epitaxial layer on the sapphire substrate.

Another method embodying the present invention, for growing an $Hg_{1-x}Cd_xTe_{1-z}Se_z$ epitaxial layer comprises steps of:-

(a) forming a CdTe crystalline layer on a sapphire substrate,

(b) growing an $Hg_{1-x}Cd_xTe$ layer on the sapphire substrate in a manner described above,

(c) heating an enclosure comprising the substrate with $Hg_{1-x}Cd_xTe$ layer thereon and a source, the source including an off-stoichiometric melt comprising Hg, Cd, Te and Se elements, and subjecting the system to isothermal vapour-phase epitaxy in three-phase equilibrium; whereby the $Hg_{1-x}Cd_xTe_{1-z}Se_z$ epitaxial layer is grown on the sapphire substrate.

General features of methods embodying the present invention for quaternary compound semiconductor layers having compositions of $(A_{1-x}B_x)_{1-y}B'_yC$ (first quaternary) or $A_{1-x}B_xC_{1-z}C'_z$ (second quaternary) will be explained below. In the above formulae, B and B' are different and may be any of Cd, Zn, Mn and Fe, and C and C' are different and may be of Te, S and Se.

A crystalline layer represented by a chemical formula BC is first grown on a sapphire substrate, thickness of the grown layer being denoted as t. Next, the substrate with the BC layer and a source are put into an enclosure, the source comprising an off-stoichiometric melt composed of A, B and C elements, wherein A denotes Hg, and B and C are as defined previously, and subjected to isothermal vapour-phase epitaxy in three-phase equilibrium, resulting in formation of an $A_{1-x}B_{xx}C$ epitaxial layer having a thickness $T_3$.

Next, the sapphire substrate with $A_{1-x}B_xC$ epitaxial layer and another source comprising an off-stoichiometric melt composed of either A, B, B' and C elements (first quaternary) or A, B, C and C' elements (second quaternary), wherein A denotes Hg and B, B', C and C' are as defined previously, are subjected to isothermal vapour-phase epitaxy in three-phase equilibrium, resulting in the formation of either $(A_{1-x}B_x)_{1-y}B'_yC$ or $A_{1-x}B_xC_{1-z}C'_z$ respectively.

It is assumed that the lattice constant of the $A_{1-x}B_xC$ epitaxial layer having thickness $T_3$ is $a_3$, and further thickness and lattice constant of the grown quaternary are $T_4$ and $a_4$ for the first quaternary, and $T_4'$ and $a_4'$ for the second quaternary. Then $T_4$ and $T_4'$ are given by the following equations:-
$T_4 = T_3a_4/(1-y)a_3$; and
$T_4' = T_3a_4'/(1-z)a_3$.

In determining the elements for making up the intermediate $A_{1-x}B_xC$ ternary layer, it is a necessary condition that a dissociation pressure of element B' is greater than that of element B (first quaternary), and a dissociation pressure of element C' is greater than that of element C (second quaternary).

An embodiment of the present invention provides a method of growing a II-VI group ternary or quaternary semiconductor epitaxial layer on a substrate, for example a method of growing a HgCdTe ternary semiconductor epitaxial layer, the method comprising the steps of:
(a) providing a substrate, for example of sapphire, which has no interdiffusion with the layer to be deposited thereon,
(b) first growing a CdTe semiconductor crystalline layer on the substrate by a conventional method,
(c) disposing the substrate with the CdTe crystalline layer and a source in an enclosure, the source comprising Te-rich Hg-Cd-Te melt of a predetermined composition,
(d) heating the substrate and source at a predetermined temperature and growing HgCdTe semiconductor on the CdTe crystalline layer in three-phase equilibrium condition, and
(e) maintaining the step (d) until the whole CdTe crystalline layer is converted to the ternary semiconductor having a predetermined composition of $Hg_{1-x}Cd_xTe$.

An embodiment of the present invention can further provide a sensing device formed using the above method. The present invention still further provides a method of growing other ternary or quaternary semiconductor layers.

An embodiment of the present invention provides a method of growing an epitaxial layer of a ternary compound semiconductor, said method comprising the steps of:-
(a) providing a substrate which has no interdiffusion reaction with a deposited semiconductor layer thereon,
(b) growing a semiconductor crystalline layer on said substrate, the semiconductor crystalline layer composed of at least plural elements comprised in said ternary compound semiconductor,
(c) disposing said substrate with the crystalline layer and a source in an enclosure, the source comprising all elements comprised in said ternary compound semiconductor and having a composition of off-stoichiometric melt,
(d) heating both said substrate with semiconductor crystalline layer and source, controlling the substrate temperature and the source temperature independently, and putting said semiconductor crystalline layer and source in three-phase equilibrium condition and growing said ternary compound semiconductor on said semiconductor crystalline layer, wherein vapours from said melt are transported to said semiconductor crystalline layer on the substrate, and
(e) maintaining the step (d) until whole said semiconductor crystalline layer is converted to said ternary compound semiconductor.

In the method said ternary compound may be denoted by a formula $A_{1-x}B_xC$, x being a mole fraction of BC, and wherein said A denotes Hg and B denotes any one selected among a group of Cd, Zn, Mn and Fe, and C denotes any one selected among a group of Te, S and Se.

In the method said semiconductor crystalline layer on the substrate may be of BC, whereby B is selected as the element having the lowest partial pressure during the growth among those for said three elements.

In the method said step (e) may continue for a duration until a thickness T of the grown epitaxial layer of the ternary compound semiconductor

reaches $ta_2/xa_1$, where $a_1$ and $a_2$ denote lattice constants of said semiconductor crystalline layer and the grown ternary semiconductor respectively and t denotes the thickness of initial semiconductor crystalline layer.

The method may further comprise step (f), after the step (e), whereby another ternary compound semiconductor layer is grown on said ternary compound semiconductor, an x-value of said another ternary compound semiconductor being different from an x-value of said ternary compound semiconductor;

    (f) heating said substrate with said ternary compound semiconductor and said source for epitaxial growth at different temperatures with each other.

The source temperature may be controlled to be lower than the temperature of the substrate.

The method may further comprise step (b$'$) after the step (b), thereby the patterned epitaxial layer of ternary compound semiconductor being formed;

(b$'$) removing selectively said semiconductor crystalline layer and exposing said substrate.

In the method said ternary compound may be $Hg_{1-x}Cd_xTe$ and said semiconductor crystalline layer may be of CdTe.

The source may be of Te-rich Hg-Cd-Te melt.

An embodiment of the present invention provides a method of growing an epitaxial layer of a quaternary compound semiconductor $(A_{1-x}B_x)_{1-y}B'_yC$, wherein A denotes Hg, and B and B$'$ denote different element selected among a group of Cd, Zn, Mz and Fe, and C denotes any one selected among a group of Te, S and Se, said method comprising steps of:-

    (a) providing a substrate which has no interdiffusion reaction with a deposited semiconductor layer thereon,

    (b) growing a semiconductor ternary crystalline layer of $A_{1-x}B_xC$ on said substrate,

    (c) disposing said substrate with the ternary crystalline layer and a source in an enclosure, the source comprising all elements A, B, B$'$ and C comprised in said quaternary compound semiconductor and having a composition of off-stoichiometric melt,

    (d) heating both said substrate with the ternary crystalline layer and source at a predetermined temperature, and putting said ternary crystalline layer and source in three-phase equilibrium condition and growing said quaternary compound semiconductor on said ternary crystalline layer, wherein vapours from said melt are transported to said ternary crystalline layer on the substrate, and

    (e) maintaining the step (d) until whole said ternary crystalline layer is converted to said quaternary compound semiconductor.

The $(A_{1-x}B_x)_{1-y}B'_yC$ epitaxial layer may be of $(Hg_{1-x}Cd_x)_{1-y}Zn_yTe$, and the $A_{1-x}B_xC$ ternary crystalline layer of $Hg_{1-x}Cd_xTe$.

An embodiment of the present invention provides a method of growing an epitaxial layer of a quaternary compound semiconductor $A_{1-x}B_xC_{1-z}C'_z$, wherein A denotes Hg, and B denotes any one selected among a group of Cd, Zn, Mn and Fe, and C and C$'$ denote different element selected among a group of Te, S and Se, said method comprising the steps of:-

    (a) providing a substrate which has no interdiffusion reaction with a deposited semiconductor layer thereon,

    (b) growing a semiconductor ternary crystalline layer of $A_{1-x}B_xC$ on said substrate,

    (c) disposing said substrate with the ternary crystalline layer and a source in an enclosure, the source comprising all elements A, B, C and C$'$ comprised in said quaternary compound semiconductor and having a composition of off-stoichiometric melt,

    (d) heating both said substrate with the ternary crystalline layer and source at a predetermined temperature, and putting said ternary crystalline layer and source in three-phase equilibrium condition and growing said quaternary compound semiconductor on said ternary crystalline layer, wherein vapours from said melt are transported to said ternary crystalline layer on the substrate, and

    (e) maintaining the step (d) until whole said ternary crystalline layer is converted to said quaternary compound semiconductor.

The $A_{1-x}B_xC_{1-z}C'_z$ epitaxial layer may be of $Hg_{1-x}Cd_xTe_{1-z}Se_z$, and said $A_{1-x}B_xC$ ternary crystalline layer of $Hg_{1-x}Cd_xTe$.

Furthermore, another aspect of the present invention provides a sensing device utilising group II-VI ternary compound semiconductor, said device comprising:-

a sapphire ($Al_2O_3$) substrate, and

a monocrystalline ternary layer of $Hg_{1-x}Cd_xTe$ grown directly on said substrate, wherein the amount x denoting a mole fraction of CdTe is substantially uniform throughout the thickness of the grown ternary layer.

The surface of said monocrystalline ternary layer may be covered by another ternary compound semiconductor layer having a different x-value larger than said amount x.

The monocrystalline ternary layer may be of a selectively patterned structure on the substrate.

An embodiment of the present invention provides sensing device utilising group II-VI ternary compound semiconductor, said device comprising:-

a substrate which has no interdiffusion reaction with a deposited semiconductor layer thereon, and
a monocrystalline ternary layer of $Hg_{1-x}Cd_xTe$ formed directly on said substrate, wherein said monocrystalline ternary layer is formed by putting a CdTe crystalline layer preliminary formed on the substrate and a source of Te-rich Hg-Cd-Te melt having a predetermined composition in a three-phase equilibrium, thereby the CdTe crystalline layer being converted to said $Hg_{1-x}Cd_xTe$ layer.

In an embodiment of the invention the substrate may be any one selected from a group of sapphire ($Al_2O_3$), magnesium oxide (MgO), zirconium oxide (ZrO), magnesium aluminium oxide ($MgO.Al_2O_3$) and silicon covered with silicon oxide ($SiO_2$).

## Claims

1. A method of growing a ternary or quaternary compound semiconductor layer, including:-
exposing in an enclosure
(a) an initial layer comprising at least two of the elements of the compound semiconductor, and
(b) a source comprising all the elements of the compound semiconductor and having the composition of an off-stoichiometric melt,
heating the initial layer and the source, in the enclosure, to place them in a three-phase equilibrium condition, to grow the compound semiconductor layer on/from the initial layer, vapours from the source being transported to the initial layer.
2. A method as claimed in claim 1, wherein the initial layer is patterned, thereby to provide for the growth of a patterned compound semiconductor layer.
3. A method as claimed in claim 1 or 2, wherein the temperature of the initial layer and the temperature of the source are independently controlled in the heating.
4. A method as claimed in claim 1, 2 or 3, wherein the temperature of the source is controlled to be lower than the temperature of the initial layer.
5. A method as claimed in claim 1, 2, 3 or 4, wherein a further semiconductor layer, having the same constituent elements as said compound semiconductor layer present in different proportions, is formed on said compound semiconductor layer by changing the heating temperature conditions.
6. A method as claimed in any of claims 1 to 5, wherein the compound semiconductor is a ternary semiconductor.
7. A method as claimed in any of claims 1 to 6, wherein the compound semiconductor is a ternary semiconductor of the formula
$A_{1-x}B_xC$
where

A denotes Hg
B denotes an element selected from Cd, Zn, Mn, Fe
C denotes an element selected from Te, S, Se.
8. A method as claimed in claim 7, wherein the heating is continued until the grown thickness of the compound semiconductor is $ta_2/xa_1$, where $a_1$ and $a_2$ are lattice constants of the initial layer, being a crystalline semiconductor layer, and of the compound semiconductor respectively, and t is the initial thickness of the initial layer.
9. A method as claimed in claim 7 or 8, wherein the initial layer is of BC.
10. A method as claimed in claim 7, 8 or 9, wherein the ternary semiconductor is $Hg_{1-x}Cd_xTe$ and the initial layer is of CdTe.
11. A method as claimed in claim 10, wherein the source is of Te-rich Hg-Cd-Te melt.
12. A method as claimed in any of claims 1 to 5, wherein the compound semiconductor is a quaternary semiconductor.
13. A method as claimed in claim 12, wherein the initial layer is a double layer, with first and second sub-layers containing respective different pairs of elements of the compound semiconductor.
14. A method as claimed in claim 12 or 13, wherein the compound semiconductor is of the formula
$A_{1-x-z}B_xB'_zC$
where

A denotes Hg
B and B' denote respective different elements selected from Cd, Zn, Mn, Fe
C denotes an element selected from Te, S, Se.
15. A method as claimed in claim 14 read as appended to claim 13, wherein the sub-layers are of BC and B'C respectively.
16. A method as claimed in claim 15, wherein the thicknesses of the BC and B'C sub-layers are initially in the ratio x to z.
17. A method as claimed in claim 12, wherein the compound semiconductor is a quaternary semiconductor of the formula
$(A_{1-x}B_x)_{1-y}B'_yC$
where

A denotes Hg
B and B' denote respective different elements selected from Cd, Zn, Mn, Fe
C denotes an element selected from Te, S, Se.
18. A method as claimed in claim 17, wherein the quaternary semiconductor is $(Hg_{1-x}Cd_x)_{1-y}Zn_yTe$.
19. A method as claimed in claim 17, wherein the compound semiconductor is a quaternary semiconductor of the formula
$A_{1-x}B_xC_{1-z}C'_z$
where

A denotes Hg
B denotes an element selected from Cd, Zn, Mn, Fe

C and C' denote respective elements selected from Te, S, Se.

20. A method as claimed in claim 19, wherein the compound semiconductor is $Hg_{1-x}Cd_xTe_{1-z}Se_z$.

21. A method as claimed in any of claims 17 to 20, wherein the initial layer is of $A_{1-x}B_xC$.

22. A method as claimed in any of claims 17 to 21, wherein the initial layer is itself grown as a compound semiconductor layer by a process as claimed in any of claims 6 to 11.

23. A method as claimed in any preceding claim, wherein the initial layer is provided on a substrate which exhibits substantially no interdiffusion reaction with layer material thereon.

24. A method as claimed in claim 23 read as appended to claim 2, wherein the substrate is exposed between parts of the patterned initial layer.

25. A method as claimed in claim 23 or 24, wherein the substrate is of sapphire ($Al_2O_3$), magnesium oxide (MgO), zirconium oxide (ZrO), magnesium aluminium oxide ($MgO.Al_2O_3$), or silicon covered with silicon dioxide ($SiO_2$).

26. A method as claimed in any preceding claim, wherein the whole of the initial layer is converted to compound semiconductor.

27. A sensing device utilizing a compound semiconductor layer grown by a method as claimed in any preceding claim.

28. A device as claimed in claim 27, comprising a monocrystalline ternary compound semiconductor layer of $Hg_{1-x}Cd_xTe$ grown directly on the substrate by a method as claimed in claim 23, 24 or 25, when read as appended to claim 11.

29. A device as claimed in claim 27, having a sapphire ($Al_2O_3$) substrate and a monocrystalline ternary compound semiconductor layer of $Hg_{1-x}Cd_xTe$ grown directly on the substrate, wherein x is substantially uniform throughout the thickness of that layer.

30. A device as claimed in claim 29, wherein said monocrystalline ternary compound semiconductor layer is covered by another ternary compound semiconductor layer of a larger x-value.

31. A sensing device utilising group II-VI ternary compound semiconductor, said device comprising:-
a sapphire ($Al_2O_3$) substrate, and
a monocrystalline ternary layer of $Hg_{1-x}Cd_xTe$ grown directly on said substrate, wherein the amount x denoting a mole fraction of CdTe is substantially uniform throughout the thickness of the grown ternary layer.

32. A device as claimed in claim 31, the surface of said monocrystalline ternary layer being covered by another ternary compound semiconductor layer having a different x-value larger than said amount x.

33. A device as claimed in claim 31 or 32, the monocrystalline ternary layer being of a selectively patterned structure on the substrate.

*FIG.1(a)*

*FIG. 1(b)*

°C

↑600

Temp.

Position ⟶

PRIOR ART

*FIG. 2*

PRIOR ART

FIG. 3    PRIOR ART

FIG. 4

FIG. 5

FIG. 6

Mole fraction x of $Hg_{1-x}Cd_xTe$

FIG. 7

FIG. 8

*FIG. 9*

*FIG.10*

*FIG.11*

FIG. 12

FIG. 13(a)

FIG. 13(b)

FIG. 13(c)

FIG. 13(d)